(19) Europäisches Patentamt
European Patent Office
Office européen des brevets

(11) Publication number : **0 235 248 B1**

(12) **EUROPEAN PATENT SPECIFICATION**

(45) Date of publication of patent specification : **01.03.95 Bulletin 95/09**

(51) Int. Cl.$^6$ : **H01L 29/864**

(21) Application number : **86905487.4**

(22) Date of filing : **10.07.86**

(86) International application number : **PCT/US86/01445**

(87) International publication number : **WO 87/00693 29.01.87 Gazette 87/03**

# (54) DETECTOR AND MIXER DIODE OPERATIVE AT ZERO BIAS VOLTAGE AND FABRICATION PROCESS THEREFOR.

(30) Priority : **12.07.85 US 754693**

(43) Date of publication of application : **09.09.87 Bulletin 87/37**

(45) Publication of the grant of the patent : **01.03.95 Bulletin 95/09**

(84) Designated Contracting States : **DE FR GB**

(56) References cited :
**FR-A- 2 345 814**
**US-A- 3 398 334**
**US-A- 4 410 902**
**APPLIED PHYSICS LETTERS, vol. 43, no. 1, July 1983, pages 90-92, American Institute of Physics, New York, US; J. JANG et al.: "New amorphous silicon majority-carrier device"**

(56) References cited :
**ELECTRONICS DEVICES, vol. 19, no. 5, March 1983, pages 181-183, London, GB; T.M. WOODCOCK et al.: "Bulk unipolar diodes in MBE GaAs"**
**Electronics Letters, 3 March 1983, vol. 19, no. 5, pages 181-183**
**R.K. Willardson et al.: "Semiconductors and Semimetals", vol. 15, Contacts, Junctions, Emitters, Academic Press, 1981, pages 30 and 31.**

(73) Proprietor : **Hewlett-Packard Company**
**Mail Stop 20 B-O,**
**3000 Hanover Street**
**Palo Alto, California 94304 (US)**

(72) Inventor : **ZURAKOWSKI, Mark, P.**
**4750 Sunshine Avenue**
**Santa Rosa, CA 95405 (US)**

(74) Representative : **Colgan, Stephen James et al**
**CARPMAELS & RANSFORD**
**43 Bloomsbury Square**
**London WC1A 2RA (GB)**

**EP 0 235 248 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### Technical Field

This invention relates generally to semiconductor diode detectors useful for microwave and millimeter wave applications, and more particularly to such detectors which are operative at high detection efficiencies with zero bias voltage. Additionally, the multi-functional structure of the diode detector disclosed and claimed herein is uniquely adapted to operate in the anti-parallel mixing mode with an identical reversely poled structure to form a highly symmetrical mixer diode pair, also operable with zero volts bias and substantially free of odd order harmonic mixing products.

### Background Art

In the field of microwave and millimeter detection, it is a common practice to provide a predetermined bias voltage on a semiconductor diode in order to set the DC operating point on a nonlinear region of the diode's current-voltage (I-V) characteristic in order to provide for maximum detection efficiency. Typically, this DC bias voltage is on the order of 0.7 volts where the diode is highly conductive in a range on one side of the DC bias voltage point and rather lighty conductive in a range on the other side of this DC bias voltage.

There are, however, several significant disadvantages in the requirement for a DC bias voltage on the diode detector. First, the requirement per se of DC bias circuitry between a power supply and the detector diode adds cost and complexity to the detector arrangement. Secondly, there is a certain amount of noise associated with the DC bias voltage, and this noise degrades the sensitivity and decreases the dynamic range of the detection. Thirdly, the bias voltage is thermally sensitive and will therefore frequently cause the DC bias operating point on the diode's I-V characteristic to be shifted in response to changes in ambient temperature at the DC bias source.

Similarly, when employing mixer diodes, it has been a common practice to provide a DC bias voltage across the mixer diode or diodes in order to establish a desired operating point on the I-V characteristic of these diodes. One such mixer diode structure is disclosed for example by Malik in U.S. Patent 4,410,902. However, an additional problem in the Malik mixer structure arises from the fact that there will be some extraneous and undesirable doping in the body of the Malik structure from impurities in the substrate moving upwardly into the epitaxial layers thereon. This doping results in an unevenly distributed and extraneous impurity profile across these layers, and this profile in turn produces dissimilar and asymmetrical I-V curves in the first and third quadrants of the device's composite I-V characteristic. Such asymmetrical I-V characteristics ultimately result in the generation of unwanted odd harmonic signals of the fundamental mixing frequency.

For a further discussion of this problem of extraneous doping in mixer structures of the type disclosed by Malik in U.S. Patent 4,410,902, reference may be made to an article by S. C. Palmateer, et al., entitled "A study of substrate effects on planar doped structures in gallium arsenide grown by molecular beam epitaxy", Institute Physics Conference, Serial Number 65: Chapter 3, presented at the International Symposium of Gallium Arsenide and Related Compounds, Albuquerque, New Mexico, 1982, at page 149 et seq.

In the field of diode detection there has been at least one attempt to provide a detector diode which operates with zero bias. Such an attempt is evidenced for example in U.S. Patent 3,968,272 issued to Anand. However, the Anand device relies upon the reaction of a semiconductor surface with certain metals in a controlled manner. It is well known that such semiconductor surface chemistry is difficult to control and this fact will in turn affect device yields and repeatability of results. Additionally, using the Anand process stable barrier heights have only been demonstrated in silicon which has a lower electron velocity than gallium arsenide, and thus operates at slower speeds than GaAs. Also, silicon has a higher parasitic capacitance than GaAs, a fact which further contributes to the slower speeds of silicon devices.

Circuitry having the features in the pre-characterising portion of claim 1 are known from US-A- 33 98 334.

### Disclosure of Invention

The general purpose of the present invention is to provide new and improved circuitry including a diode structure which is operative at zero volts bias with a high detection efficiency and which therefore overcomes the aforedescribed disadvantages of the prior art. This problem is solved by the invention defined in claim 1. An embodiment of this invention provides a diode structure which is uniquely suited and adapted to operate with an identical, reversely poled diode structure in an anti-parallel mixing mode, having a highly symmetrical I-V characteristic and substantially free of odd order harmonic generation. Thus, this multi-functional diode structure may advantageously be constructed in a single wafer fabrication process which, in a preferred embodiment, employs molecular beam epitaxial growth to achieve high quality, high purity, and high thickness control in the multiple epitaxial layers. The resultant diode structure may be operated either as an efficient detector diode, or it may be connected in the anti-parallel mode with an identical mixer diode to exhibit a highly symmetrical composite I-V characterisitic necessary for the prevention of odd harmonic frequency generation.

The above purposes, advantages, and other novel features of this invention will become better understood in the following description of the accompanying drawings wherein:

## Brief Description of the Drawings

Figures 1A and 1B illustrate the basic structural configuration of the novel detector/mixer diode according to the invention.

Figures 2A and 2B illustrate the majority carrier potential barrier extending across the various layers of the diode.

Figures 2C and 2D illustrate the increasing majority carrier potential across the diode structure of Figure 2A for forward bias and reverse bias conditions, respectively.

Figures 3A through 3D illustrate respectively four (4) alternative structural embodiments of the invention wherein either the exact position or the conductivity type of the thin critical layer are different in each structure, but are operative to functionally accomplish the same detection or mixing function to be further described.

Figures 4A and 4B show a diode detection network (and associated I-V characteristic) utilizing the diode according to the invention.

Figures 5A and 5B show an anti-parallel diode mixer pair (and associated I-V characteristic) for the mixer diode according to the invention.

## Best Mode For Carrying Out The Invention

Referring now to Figures 1A and 1B, the diode structure is indicated generally as 10 and includes a semi-insulating gallium arsenide (GaAs) substrate 12 which is typically $10^7$ to $10^8$ ohm-centimeters in resistivity and 8 to 25.4 μ (10 mils) in thickness. An N type epitaxial layer 14 is deposited on the substrate 12 and is typically 500 nm (5000 Angstroms) in thickness and has a doping concentration of about $10^{18}$ silicon dopant atoms per cubic centimeter. The next layer 16 is an intrinsic or "I" layer of approximately 300 nm (3000 Angstroms) in thickness and typically has a doping concentration of about $10^{14}$ dopant atoms per cubic centimeter.

The intrinsic layer 16 has a thin P type layer 18 of epitaxial material deposited on its upper surface, and the P type layer 18 is also referred to herein as the critical layer. This layer 18 may range in thickness between 2.5 - 14 nm (25 and 140 Angstroms), but will normally be about 4 - 5 nm (40-50 Angstroms) in thickness, and thus sufficiently thin so as to be fully depleted of majority carriers (or electrons) in this structure. The dopant concentration of layer 18 will be about $8x10^{18}$ beryllium atoms per cubic centimeter. A top N type layer 20 is epitaxially deposited as shown on the top surface of P type layer 18, and this upper layer 20 will typically be about 300 (3000 Angstroms) in thickness and will have a carrier concentration of about $5x10^{18}$ silicon atoms per cubic centimeter.

The type of semiconductor material of the structures described herein is not critical, and such type only determines the potential barrier height range that can be achieved for these structures which are all formed preferably using molecular beam epitaxial (MBE) deposition processes. Such known and commercially available computer controlled MBE processes are preferred in that they are presently capable of providing the best repeatable layer thickness control and doping uniformity of any presently available epitaxial processes. Although the critical layer 18 may range in thickness from 2.5 - 14 nm (25 to 140 Angstroms), it is preferred that it be 4 to 5 nm (40 to 50 Angstroms) in thickness, with a maximum acceptable tolerance of ± 0.5 nm (± 5 Angstroms).

In the MBE best mode process used in constructing the devices disclosed and claimed here, both silicon and beryllium were alternated in the MBE epi system for N and P type doping respectively.

The presently known best mode for carrying out the MBE epitaxial deposition according to the invention is the use of an epitaxial reactor known in the trade as the VARIAN GEN-2 available from VARIAN ASSOCIATES of Palo Alto, California, with MBE shutter control provided by a Hewlett Packard HP 1000 computer. For convenience, a summary table of the various layer thickness or thickness range and doping levels is given below for the device structure of Figure 1A. It will be understood, however, that these doping levels and thickness apply equally to corresponding layers of the devices subsequently described with reference to Figures 3A-3D.

TABLE

| LAYER | THICKNESS | DOPING CONCENTRATION |
|---|---|---|
| 14 | 500 nm (5000 Å) | $10^{18}$ silicon atoms/cc |
| 16 | 300 nm (3000 Å) | $10^{14}$ atoms/cc |
| 18 | 2.5-14 nm (25-140 Å) | $8\times10^{18}$ Be atoms/cc |
| 20 | 300 nm (3000 Å) | $5\times10^{18}$ silicon atoms/cc |

For a further discussion of this MBE technology, reference may be made to Proceedings of the Fifth Molecular Beam Epitaxy Workshop edited by John R. Arthur, attended 6-7 October, 1983, Georgia Institute of Technology, Atlanta, Ga. and published for the American Vacuum Society by the American Institute of Physics, New York 1984, incorporated herein by reference.

The semiconductor device of Figure 1A has electrons as its majority carriers, but if N layers are changed to P layers and vice versa, the majority carriers become holes. Ohmic or non rectifying contacts 22 and 24 are made to the N type layers 20 and 14 respectively in Figure 1A, and the diode structure is etched in a mesa-like configuration with the side wall contours shown and isolated physically on the N layer 14 from the ohmic contact 24. However, if a conducting substrate 12 is used instead of a semi-insulating substrate material, then the N layer 14 can be omitted and the intrinsic layer 16 positioned directly atop the proposed or alternative conductive substrate material (not shown). The exact mesa type configuration of the NPI structural portion of Figure 1B may be determined by mesa etching, ion milling or other similar known processing methods.

The proper thickness and doping levels of the above described semiconductor layers of the diode structure are essential to optimum device operation. The top layer 20 needs to be thick enough so that it is not fully depleted of majority carriers during operation, and it also must be sufficiently thick to provide an adequate barrier between the ohmic contact 22 (which diffuses partially into the top N layer during alloying) and the thin critical P layer 18. If the N layer 20 doping level is sufficiently high, non alloyed contacts can be utilized and the diffusion of the metal will not be a problem. The thickness and impurity doping level of the P type layer 18 and the impurity doping level in the top N layer 20 are all determinative of the height of the potential barrier at the PN junction between layers 18 and 20. This condition is quite different from the planar doped barrier diode of the above identified Malik U.S. Patent 4,410,902 where the potential barrier height is determined by the P layer doping, the P layer thickness and the thicknesses of the two (2) intrinsic layers used therein. The P layer 18 in Figures 1A and 1B needs to be sufficiently thin so that it is fully depleted of majority carriers, and the intrinsic or lightly doped layer 16 must be appreciably depleted of majority carriers so as to give optimum asymmetry to the I-V characteristic of the diode.

The thickness and doping level of the bottom N layer 14 is not critical as long as a good ohmic contact can be made to this layer and as long as the layer 14 is thick enough and sufficiently doped to provide a low series resistance on the order of 0.5 to 10 ohms. In fact, these devices can be made on a conductive substrate, in which case no bottom N layer 14 is needed.

Referring now to Figures 2A through 2D, the diagrams shown in these figures illustrate the operation of the diode structure according to the invention. The shaded portion of Figure 2A indicates the depleted regions of the various epitaxial layers at zero bias, and the diagram of Figure 2B illustrates the varying majority carrier potential gradient horizontally across the structure of the device. Since the intrinsic layer 16 is relatively large in thickness and high in resistance compared to any other region of the device structure, most of the potential drop occurs across this region 16. Under forward bias, the depleted region of the top N layer 20 grows at the expense of the depleted region of the bottom N layer 14 thereby causing the bottom N layer 14 to increase its potential relative to that of the top N layer. This characteristic allows electrons to flow from region 14 to region 20.

Figure 2C illustrates the increasing majority carrier potential across the diode structure under forward bias conditions, whereas Figure 2D illustrates the increasing majority carrier potential across the diode structure under reverse bias conditions. The difference between forward and reverse bias is that it takes more voltage to achieve the same current level in reverse bias because most of the voltage is dropped across the intrinsic layer 16. Only a small fraction of the applied voltage is available to change the potential of layer 20, whereas most of the voltage is available to change the potential of layer 14.

Referring now to Figures 3A through 3D, there are shown respectively four (4) structural modifications of the diode structure in Figure 1B, and all of these diode structural modifications in Figures 3A through 3D are

alternative embodiments of the invention. All of these alternative embodiments serve to establish the potential barrier -q.ΦB where q is the charge on an electron. This value of -q.ΦB is somewhere between zero voltage and the semiconductor bandgap voltage.

In Figure 3A the critical P layer has been moved from the top side of the intrinsic layer (Figure 1B) to the bottom surface thereof where it separates the intrinsic layer and the bottom N type layer of the device.

In Figure 3B, the diode structure has been modified to eliminate the bottom N type layer and dispose the intrinsic layer directly on the N type conductive substrate as shown.

In Figure 3C, the conductivity types and vertical geometry of the various layers of Figure 3A have been reversed, so that the critical layer is now an N type layer positioned between a top P type layer and the intrinsic layer as shown.

Finally, in Figure 3D the conductivity types of the layers of Figure 3A have been reversed in polarity as indicated.

The quantity $-q.\Phi_B$ is the zero bias barrier height in volts to overcome the potential barrier at the PN junction of the above devices and thus essentially turn on these devices to a fully conductive state. In Figure 2A and 2B for example, this barrier height is a potential somewhere between zero and the semiconductor bandgap voltage and will typically be about 0.25 electron volts. For this structure, it can be shown that:

$$-q.\Phi_B = \frac{q}{2e_s} \cdot \left[ N_A + \frac{N_A^{\,2}}{N_D} \right] \cdot t^2$$

where $e_s$ is the dielectric constant of the semiconductor material, $N_A$ is the doping concentration of the P+ critical layer 18, $N_D$ is the doping concentration of the N+ layer 20, and t is the thickness of the critical layer 18.

## Diode Detection

Referring now to Figures 4A and 4B, there is shown a conventional diode detector network including an input impedance matching resistor R, typically of about 50 ohms, a diode D, and an output capacitor C for developing a detection voltage envelope thereacross in accordance with well known detection principles. As is also well known, the detection efficiency of the diode D is directly proportional to the degree of asymmetry of its I-V characteristic as indicated in Figure 4B. Thus typical detector diodes of the prior art will have an I-V characteristic as indicated by the curved dotted line in Figure 4B and will have a very large video resistance, $R_v$, at zero bias on the order of about 600,000 ohms. Since it is generally accepted that this video resistance, $R_v$, must be on the order of 1000 ohms for maxiumum detection sensitivity, then these detector diodes of the prior art are typically DC biased to about 0.7 volts in order to reduce the video resistance to 1000 ohms.

However, as indicated by the solid dI/dV curve which is the I-V characteristic of the present invention, the video resistance at zero volts DC bias is about 1000 ohms, and thus no separate applied DC bias is required. It is to be understood however that these comparisons to the prior art diodes are based upon the same very small diode area of about 20 $\mu m^2$ (20 square microns) of anode surface area necessary to keep junction capacitance at a minimum value on the order of $10^{-14}$ farads.

## Diode Mixing

When the diode structure according to the invention is to be used in a mixer circuit, two (2) of these identical devices are connected in parallel and in reverse polarity as shown in Figure 5A in the well known "anti-parallel" mixing mode of operation. The connection of reverse poled diodes in such an anti-parallel diode network is well known in the art, and the advantage presented by the present invention is that two substantially identical mixer diodes fabricated side by side on a common semiconductor wafer will have substantially identical I-V characteristics. Thus, the net overall I-V characteristics of these two identical diodes connected in parallel is a completely symmetrical curve as shown in Figure 5B whose first quadrant contour is an identical match to its third quadrant contour, resulting in the complete elimination of mixing with odd order harmonics of the fundamental mixing frequency. This feature has the effect of lowering device noise inasmuch as it enables one to detect very small imput signals on a spectrum analyzer. Additionally, since the number of mixing products is decreased, it now becomes easier to identify the desired mixing product. This complete symmetry of I-V characteristics of the anti-parallel diode mixer pair according to this invention is not achievable by way of the above identified Malik structure by reason of the extraneous and unwanted impurity doping previously described.

Thus, there has been demonstrated a new and improved semiconductor device, which when used as a broadband non-biased detector, has a 5dB greater dynamic range and improved flatness than any known similar device on the market. The range of operation of this device has been demonstrated from DC to 110 GHz; however higher operational frequencies are expected.

When this device is used in the anti-parallel mixer configuration at millimeter wave frequencies as a high harmonic (greater than the 10th harmonic) mixer, no DC bias is needed to obtain state of the art conversion efficiencies across an entire waveguide band. This fact has been demonstrated through W band (110 GHz). Other mixers on the market today require a variable DC bias to obtain efficient mixing across these millimeter wave bands.

The present invention is not limited to the use of GaAs, and alternatively may be carried out using gallium phosphide (GaP), indium gallium arsenide (InGaAs) or other equivalent semiconductor materials or even silicon epitaxy in cases where the slower speeds of silicon are acceptable for certain applications.

Finally, the present invention is not limited to the use of MBE epitaxial processes and alternatively may employ other epitaxial processes which are capable of repeatably controlled epi growth of plus or minus (±) 2.5 nm (25 Angstroms) with uniform doping concentration. Such control and uniformity may be achievable using certain state of the art organo-metallic vapor phase epitaxial (OMVPE) processing techniques known and available to those skilled in the art.

## Industrial Applicability

This invention finds application in the field of electronic instruments, particularly of the test and measurment and millimeter wave type, in a wide variety of diode mixing and detection operations.

## Claims

**1.** Circuitry including a diode structure (10) having :

a. a single intrinsic or substantially intrinsic semiconductor layer (16) having a thickness and impurity concentration such that it is substantially depleted of majority carriers ;

b. a critical thin semiconductor layer (18) of either N or P type disposed on a surface of said intrinsic layer (16) ;

c. a layer (20) of opposite conductivity type (P or N) semiconductor material disposed on the other surface of said critical thin layer (18), to form a PN junction ;

d. a further semiconductor layer (14) of said opposite conductivity type, or a conductive substrate (12), disposed on the other surface of said intrinsic layer (16) ;

e. a first ohmic contact (22) disposed on a surface of said layer (20) of said opposite conductivity type semiconductor material ;

f. a second ohmic contact (24) disposed either on said conductive substrate (12) or on said further semiconductor layer (14) of said opposite conductivity type,

characterised in that :

the diode structure (10) is operating at zero volts DC bias at microwave or millimetre wave frequencies ;

said layer (20) of opposite conductivity type is thick enough so as not to be fully depleted of majority carriers during operation of the diode structure and so as to shield metal impurities between the first ohmic contact (22) and the critical thin layer (18) ;

said critical thin layer (18) is between 2.5 and 14 nm (25 and 140 Angstroms) in thickness, and is fully depleted of majority carriers ;

said intrinsic layer (16) is between 50 and 150 nm (500 and 15,000 Angstroms) in thickness ; and

the doping level in said intrinsic layer (16) is of the order of $10^{14}$ atoms/cc, the doping level in said critical thin layer (18) is of the order of $8 \times 10^{18}$ atoms/cc, and the doping level in said opposite conductivity type layer (20) is of the order of $5 \times 10^{18}$ atoms/cc.

**2.** Circuitry according to Claim 1, wherein the diode structure (10) is part of a diode detector circuit and has a video resistance of about 1000 ohms.

**3.** Circuitry according to Claim 1, wherein two of said diode structures (10) are connected in parallel and in

reverse polarity to form an anti-parallel mixer diode circuit, said mixer diodes being fabricated side-by-side on a common semiconductor wafer, which is common thereto, so that said diode structures have substantially identical I-V characteristics, and so that the net overall I-V characteristics define a symmetrical curve whose first quadrant contour is identical to its third quadrant contour, whereby any mixing with odd order harmonics of a fundamental mixing frequency is eliminated.

4. A circuit according to any preceding Claim, wherein said critical thin layer (18) is grown by an MBE process with a repeatably controlled EPI growth of ± 0.5 nm.

5. A circuit according to Claim 1, 2 or 4, wherein said zero bias barrier height is about 0.25 eV.

6. A circuit according to any of Claims 1 to 5, wherein said opposite conductivity type layer (20) is on the order of 30 nm (3,000 Angstroms) in thickness.

## Patentansprüche

1. Schaltung, die eine Diodenstruktur (10) einschließt, mit:
   a. einer einzelnen intrinsischen oder im wesentlichen intrinsischen Halbleiterschicht (16) mit einer Dicke und einer Störstellenkonzentration derart, daß sie im wesentlichen von Majoritätsträgern ausgeräumt ist;
   b. einer kritischen dünnen Halbleiterschicht (18), entweder vom N- oder P-Typ, die auf einer Oberfläche der intrinsischen Schicht (16) angeordnet ist;
   c. einer Schicht (20) aus einem Halbleitermaterial vom entgegengesetzten Leitfähigkeitstyp (P oder N), die auf der anderen Oberfläche der kritischen dünnen Schicht (18) angeordnet ist, um einen PN-Übergang zu bilden;
   d. einer weitere Halbleiterschicht (14) vom entgegengesetzten Leitfähigkeitstyp, oder ein leitfähiges Substrat (12), das auf der anderen Oberfläche der intrinsischen Schicht (16) angeordnet ist;
   e. einem ersten ohmschen Kontakt (22), der auf einer Oberfläche der Schicht (20) aus einem Halbleitermaterial vom entgegengesetzten Leitfähigkeitstyp angeordnet ist; und
   f. einem zweiten ohmschen Kontakt (24), der entweder auf dem leitfähigen Substrat (12) oder auf der weiteren Halbleiterschicht (14) vom entgegengesetzten Leitfähigkeitstyp angeordnet ist,
   dadurch gekennzeichnet, daß:
   die Diodenstruktur (10) bei Null Volt Gleichstrom-Vorspannung bei Microwellen- oder Millimeterwellenfrequenzen arbeitet;
   die Schicht (20) vom entgegengesetzten Leitfähigkeitstyp dick genug ist, um während des Betriebs der Diodenstruktur nicht vollständig von Majoritätsträgern ausgeräumt zu werden, und um Metallverunreinigungen zwischen dem ersten ohmschen Kontakt (22) und der kritischen dünnen Schicht (18) abzuschirmen;
   die kritische dünne Schicht (18) zwischen 2,5 und 14 nm (25 und 140 Ångström) dick ist und vollständig von Majoritätsträgern ausgeräumt ist;
   die intrinsische Schicht (16) zwischen 50 und 150 nm (500 und 15000 Ångström) dick ist; und
   der Dotierungspegel in der intrinsischen Schicht (16) im Größenbereich von $10^{14}$ Atomen/ccm ist, der Dotierungspegel in der kritischen dünnen Schicht (18) in der Größenordnung von $8x10^{18}$ Atomen/ccm ist, und der Dotierungspegel in der Schicht (20) vom entgegengesetzten Leitfähigkeitstyp in der Größenordnung von $5x10^{18}$ Atomen/ccm ist.

2. Schaltung gemäß Anspruch 1, bei der die Diodenstruktur (10) ein Teil einer Diodendetektorschaltung ist und einen Videowiderstand von etwa 1000 Ohm hat.

3. Schaltung gemäß Anspruch 1, bei der zwei der Diodenstrukturen (10) parallel und in umgekehrter Polarität verschaltet sind, um eine anti-parallele Mischerdiodenschaltung zu bilden, wobei die Mischerdioden Seite an Seite auf einem gemeinsamen Halbleiterwafer hergestellt sind, so daß die Diodenstrukturen im wesentlichen identische I-V-Charakteristika haben, und so daß die Netto-Gesamt-I-V-Charakteristika eine symmetrische Kurve definieren, deren erste Quadrantenkontur identisch zu der dritten Quadrantenkontur ist, wodurch jegliche Mischung mit ungradzahligen Harmonischen einer fundamentalen Mischfrequenz ausgeschlossen wird.

4. Eine Schaltung gemäß irgendeinem vorhergehenden Anspruch, bei der die kritische dünne Schicht (18)

durch einen MBE-Prozeß mit einem wiederholbar gesteuerten epitaxialen Aufwachsen von ± 0,5 nm aufgewachsen ist.

5. Eine Schaltung gemäß Anspruch 1, 2 oder 4, bei der die Null-Vorspannungs-Barrierenhöhe etwa 0,25 eV beträgt.

6. Eine Schaltung nach irgendeinem der Ansprüche 1 bis 5, wobei die Schicht (20) vom entgegengesetzten Leitfähigkeitstyp eine Dicke in der Größenordnung von 300 nm (3000 Ångström) hat.

## Revendications

1. Circuit incluant une structure de diode (10) comprenant:
   a. une couche semi-conductrice unique intrinsèque ou sensiblement intrinsèque (16) dont l'épaisseur et la concentration en impuretés sont telles qu'elle est sensiblement en état de déplétion de porteurs majoritaires ;
   b. une couche semi-conductrice mince critique (18) de type N ou P disposée sur une surface de ladite couche intrinsèque (16);
   c. Une couche (20) de matière semi-conductrice du type de conductivité opposé (P ou N) disposée sur l'autre surface de ladite couche mince critique (18), afin de former une jonction PN ;
   d. une autre couche semi-conductrice (14) dudit type de conductivité opposé , ou un substrat conducteur (12) disposé sur l'autre surface de ladite couche intrinsèque (16);
   e. un premier contact ohmique (22) disposé sur une surface de ladite couche (20) de ladite matière semi-conductrice du type de conductivité opposé ;
   f. un deuxième contact ohmique (24) disposé soit sur ledit substrat conducteur (12), soit sur ladite autre couche semi-conductrice (14) dudit type de conductivité opposé ,
   caractérisé en ce que:
   la structure (10) de diode fonctionne à une polarisation en courant continu de zéro volt à des fréquences de micro-ondes ou d'ondes millimétriques;
   ladite couche (20) du type de conductivité opposé est suffisamment épaisse pour ne pas être en complète déplétion de porteurs majoritaires pendant le fonctionnement de la structure de diode et de façon à former un écran pour les impuretés métalliques entre le premier contact ohmique (22) et la couche mince critique (18);
   l'épaisseur de ladite couche mince critique (18) est comprise entre 2,5 et 14 nm (25 et 140 Angstroms); et elle est en état de déplétion complète de porteurs majoritaires ;
   l'épaisseur de ladite couche intrinsèque (16) est comprise entre 50 et 150 nm (500 et 1500 Angstroms); et
   le niveau de dopage de ladite couche intrinsèque est de l'ordre de $10^{14}$ atomes/ $cm^3$, le niveau de dopage de ladite couche mince critique (18) est de l'ordre de $8 \times 10^{18}$ atomes/ $cm^3$ et le niveau de dopage dans ladite couche (20) de type de conductivité opposée est de l'ordre de $5 \times 10^{18}$ atomes/ $cm^3$.

2. Circuit selon la revendication 1, dans lequel la structure (10) de diode fait partie d'un circuit de détecteur à diode et sa résistance vidéo est d'environ 1000 ohms.

3. Circuit selon la revendication 1, dans lequel deux desdites structures (10) de diode sont reliées en parallèle et selon des polarités inverses afin de former un circuit antiparallèle à diodes mélangeuses, lesdites diodes mélangeuses étant fabriquées côte-à-côte sur une tranche semi-conductrice commune qui leur est commune, de façon que lesdites structures de diodes présentent des caractéristiques I-V sensiblement identiques et de façon que les caractéristiques I-V nettes d'ensemble définissent une courbe symétrique dont le contour dans le premier quadrant est identique au contour dans le troisième quadrant, de sorte que tout mélange incluant des harmoniques d'ordre impair d'une fréquence fondamentale de mélange est éliminé.

4. Un circuit selon une revendication précédente quelconque, dans lequel ladite couche mince critique (18) est obtenue par croissance par un processus de croissance par épitaxie par jets moléculaires, ou MBE, la croissance épitaxiale étant réglée de façon reproductible à ± 0,5 nm.

5. Un circuit selon la revendication 1, 2 ou 4, dans lequel ladite hauteur de la barrière à polarisation nulle est d'environ 0,25 eV.

6. Un circuit selon l'une quelconque des revendications 1 à 5, dans lequel l'épaisseur de ladite couche (20) du type de conductivité opposé est de l'ordre de 300 nm (3000 Angstroms).

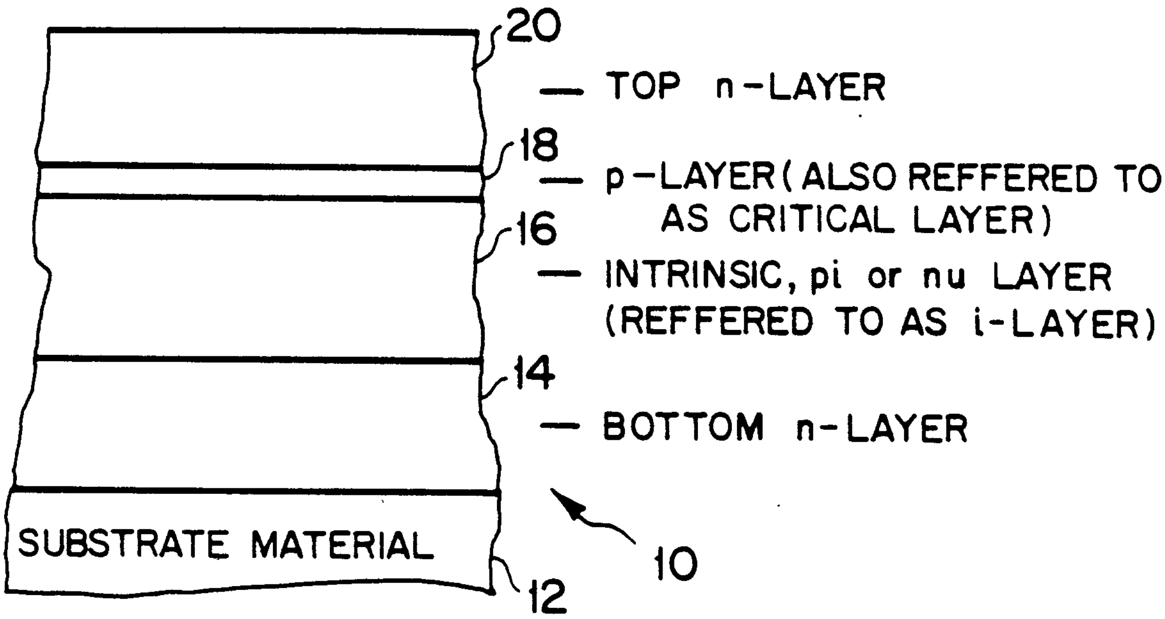
20
TOP n-LAYER
18
p-LAYER(ALSO REFFERED TO AS CRITICAL LAYER)
16
INTRINSIC, pi or nu LAYER (REFFERED TO AS i-LAYER)
14
BOTTOM n-LAYER
SUBSTRATE MATERIAL
12
10

*FIG 1A*

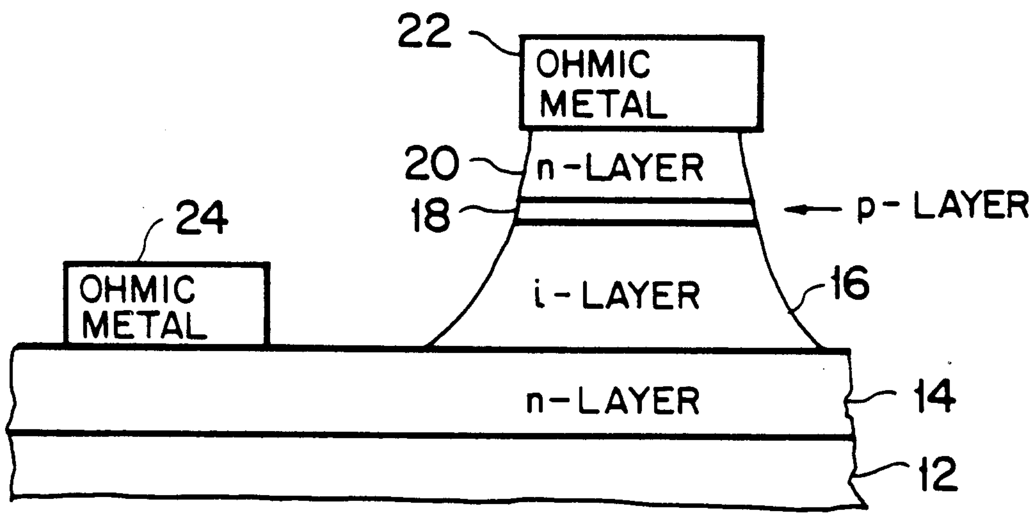
22
OHMIC METAL
20
n-LAYER
18
p- LAYER
24
OHMIC METAL
i-LAYER
16
n-LAYER
14
12

*FIG 1B*

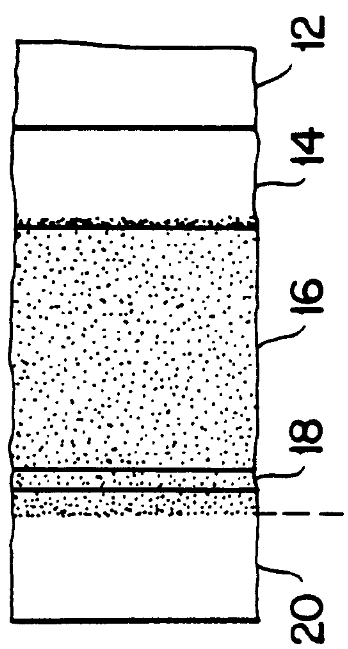


FIG 2A

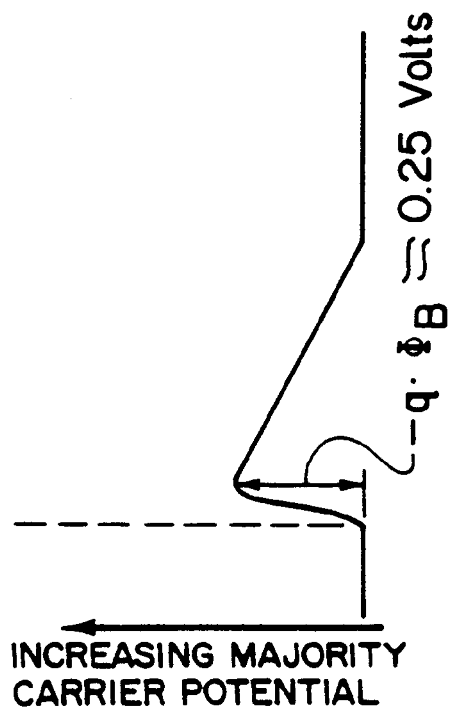


FIG 2B

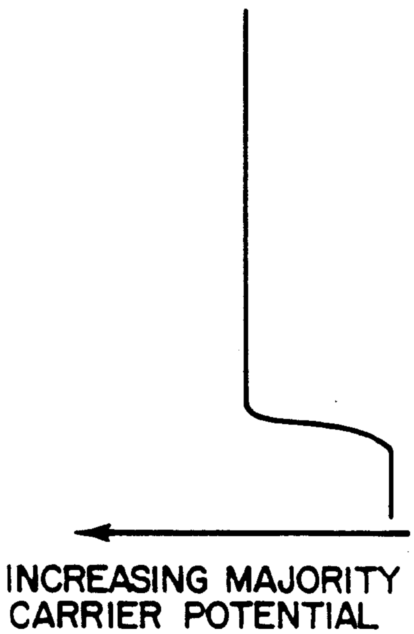


FORWARD BIAS POTENTIAL DIAGRAM

FIG 2C

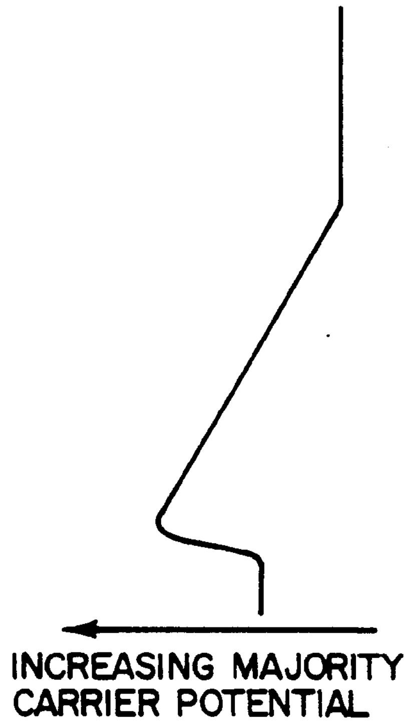


REVERSE BIAS POTENTIAL DIAGRAM

FIG 2D

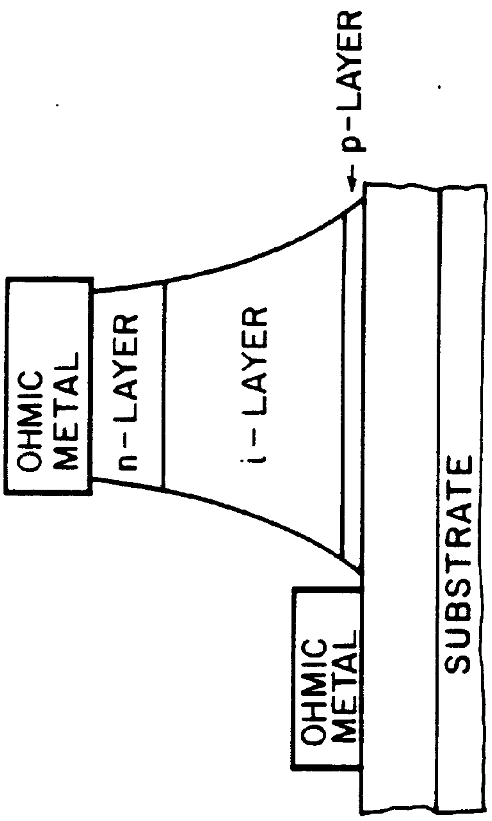


FIG 3A

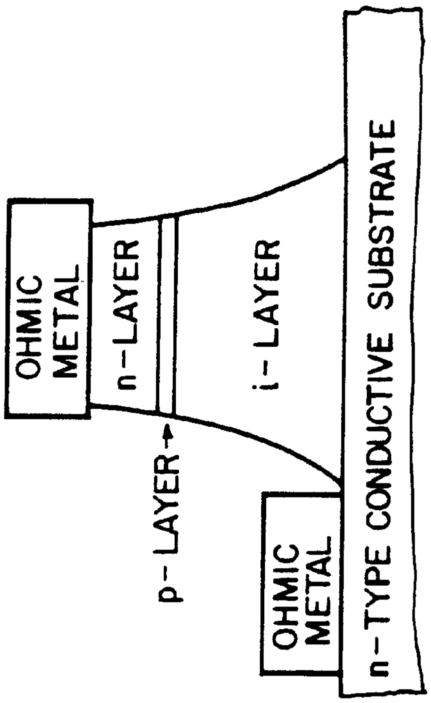


FIG 3B

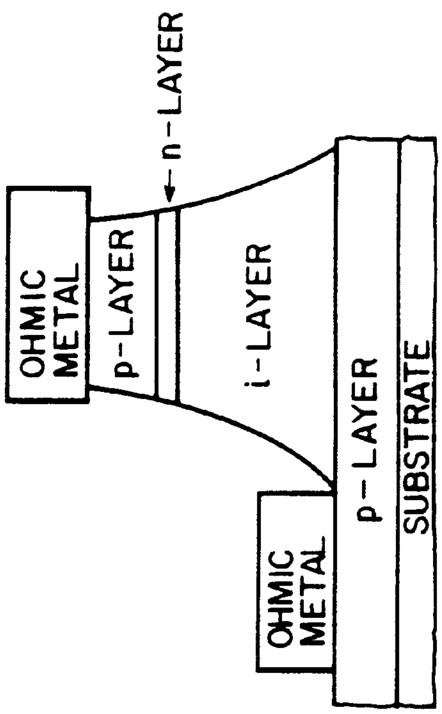


FIG 3C

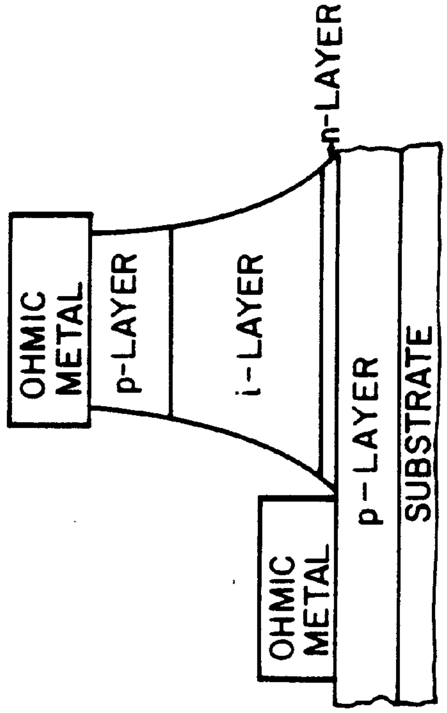


FIG 3D

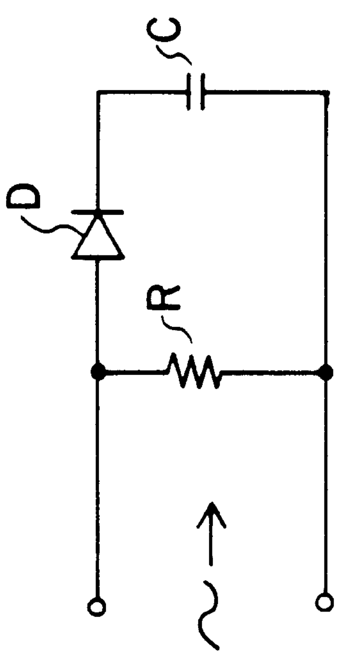


FIG 4A

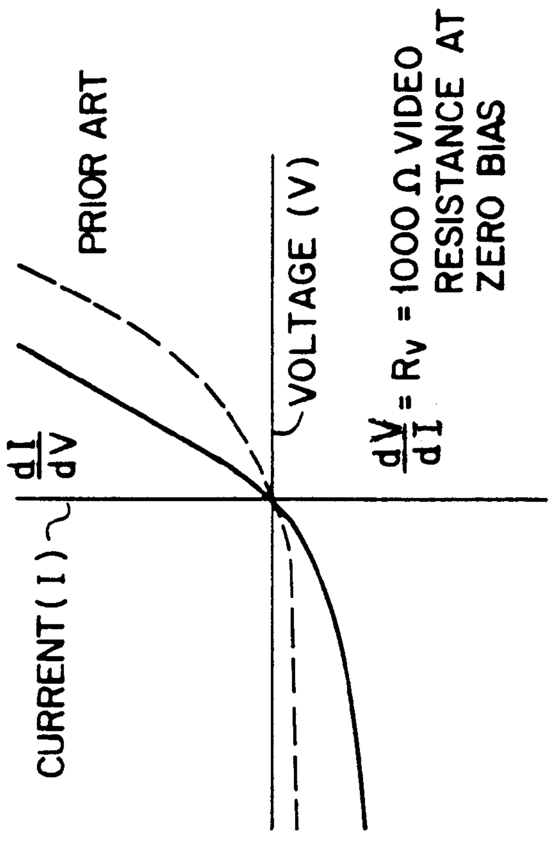


FIG 4B

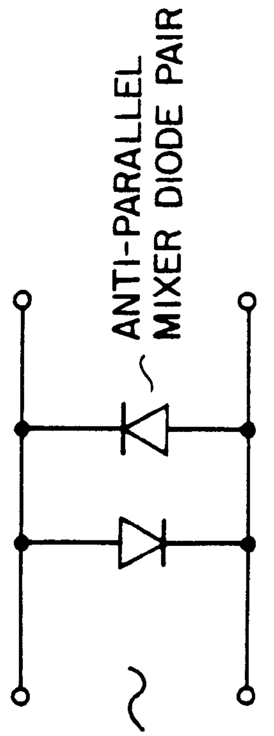


FIG 5A

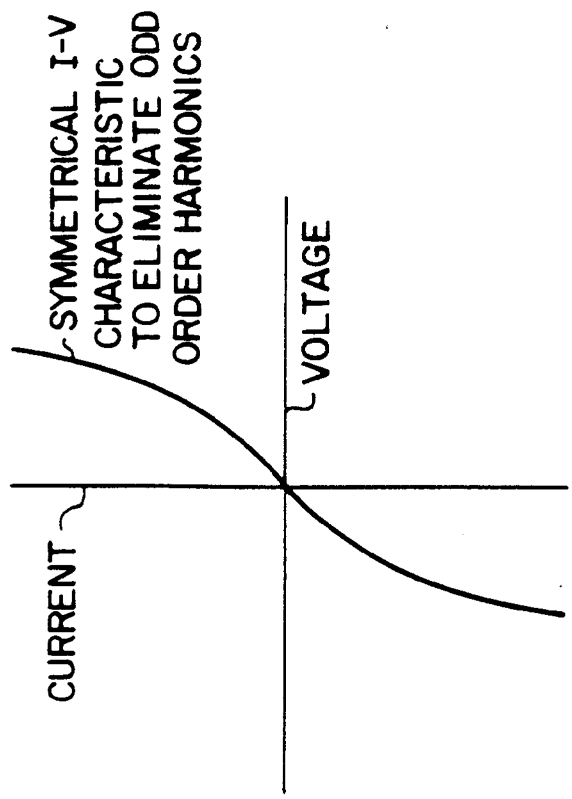


FIG 5B